(19) Europäisches Patentamt / European Patent Office / Office européen des brevets

(11) **EP 3 343 648 A1**

(12) **EUROPEAN PATENT APPLICATION**
published in accordance with Art. 153(4) EPC

(43) Date of publication:
04.07.2018 Bulletin 2018/27

(21) Application number: 16838777.7

(22) Date of filing: 09.08.2016

(51) Int Cl.:
$H01L\ 33/50^{(2010.01)}$     $C09K\ 11/02^{(2006.01)}$
$C09K\ 11/56^{(2006.01)}$     $C09K\ 11/62^{(2006.01)}$
$H01L\ 33/58^{(2010.01)}$

(86) International application number:
PCT/JP2016/003676

(87) International publication number:
WO 2017/033426 (02.03.2017 Gazette 2017/09)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
MA MD

(30) Priority: 25.08.2015 JP 2015166111

(71) Applicant: Dexerials Corporation
Tokyo 141-0032 (JP)

(72) Inventors:
• ITO, Yasushi
  Tokyo 141-0032 (JP)
• HORI, Tomomitsu
  Tokyo 141-0032 (JP)
• KISHIMOTO, Koichi
  Tokyo 141-0032 (JP)
• SATO, Noritaka
  Tokyo 141-0032 (JP)

(74) Representative: Murgitroyd & Company
Scotland House
165-169 Scotland Street
Glasgow G5 8PL (GB)

(54) **WAVELENGTH CONVERSION MEMBER, FLUORESCENT SHEET, WHITE LIGHT SOURCE DEVICE, AND DISPLAY DEVICE**

(57)    Provided is a wavelength conversion member that can be produced at low cost and can suppress temporal variation in the chromaticity of light when used in a light source device. The wavelength conversion member contains: a phosphor that performs wavelength conversion of at least a portion of incident light and releases emitted light of a different wavelength to the incident light; a light diffusing element that diffuses either or both of the incident light and the emitted light; and a base material that holds the light diffusing element. The light diffusing element is a silicone resin, and the base material includes a hydrogenated styrene copolymer.

# FIG. 2

**Description**

CROSS-REFERENCE TO RELATED APPLICATION

This application claims priority of Japanese Patent Application No. 2015-166111 (filed on August 25, 2015), the entire disclosure of which is incorporated into this application for reference.

TECHNICAL FIELD

This disclosure relates to a wavelength conversion member, a phosphor sheet, a white light source device, and a display device.

BACKGROUND

In recent years, light source devices have been disclosed that obtain white light through a combination of a light-emitting diode and a phosphor that performs wavelength conversion of a portion of light that is released by this light-emitting diode and releases light of a different wavelength. In particular, light source devices that obtain white light with a wide color gamut using a blue light-emitting diode and a wavelength conversion member containing an appropriately selected phosphor are commonly used.

One example of a wavelength conversion member for a white light source device that uses a blue light-emitting diode is a sheet-shaped phosphor layer obtained by dispersing red and green sulfide phosphors having narrow-band light emission characteristics with excellent wide color gamut characteristics in a transparent resin. Moreover, one example of this white light source device has a configuration in which a phosphor sheet including the above-described phosphor layer covers the entire light emission surface of a light source unit including the blue light-emitting diode.

The phosphor sheet normally covers the light source unit at a position with a certain degree of separation from the light source unit for reasons such as preventing degradation of phosphor used therein. In many cases, this necessitates the use of a comparatively large amount of phosphor in the phosphor sheet to ensure good optical properties (for example, luminance). Phosphors used in combination with light-emitting diodes are generally expensive and tend to constitute a large proportion in the cost breakdown of a phosphor sheet. For this reason, reduction of the amount of used phosphor and cost-reduction are important for promoting the use of phosphor sheets, and various attempts have been made to achieve these objectives.

For example, PTL 1 discloses that through use of a polymer composition obtained by dispersing a phosphor and at least two types of light dispersing materials having specific refractive indices in a polymer binder that is normally a silicone polymer, it is possible to reduce the amount of phosphor that is used and suppress variation of characteristics within a production lot.

CITATION LIST

Patent Literature

PTL 1: JP 2014-078691 A

SUMMARY

(Technical Problem)

However, studies carried out by the inventors have revealed that wavelength conversion members obtained using polymer compositions disclosed in the aforementioned patent literature each suffer from a problem that the chromaticity of light emitted via the wavelength conversion member may exhibit temporal variation.

Note that in relation to a wavelength conversion member formed using a phosphor and a light dispersing material, long-term maintenance of light chromaticity has not been conceived of or attempted up until now.

This disclosure aims to solve the conventional problems set forth above and achieve the following objectives. Specifically, one objective of this disclosure is to provide a wavelength conversion member and a phosphor sheet that can be produced at low cost and can suppress temporal variation in the chromaticity of light when used in a light source device. Another objective of this disclosure is to provide a white light source device and a display device that can be produced at low cost and in which temporal variation in the chromaticity of light is suppressed.

(Solution to Problem)

For the first time, the inventors focused on the reduction of temporal variation in chromaticity of light in relation to a wavelength conversion member formed using a phosphor and a light dispersing material. As a result of diligent studies conducted with the aim of solving the aforementioned objectives, the inventors discovered that through appropriate selection of materials used in the wavelength conversion member, the amount of phosphor that is used can be reduced to achieve cost-reduction and long-term maintenance of the chromaticity of light can be achieved. The inventors completed the present disclosure based on this discovery.

This disclosure is based on the findings made by the inventors and provides the following as a solution to the problems set forth above. Specifically, this disclosure provides:

<1> A wavelength conversion member comprising:

a phosphor that performs wavelength conversion of at least a portion of incident light and releases emitted light of a different wavelength to the incident light;
a light diffusing element that diffuses either or both of the incident light and the emitted light; and
a base material that holds the light diffusing element, wherein
the light diffusing element is a silicone resin, and
the base material includes a hydrogenated styrene copolymer.

In the wavelength conversion member according to the foregoing <1>, the use of a silicone resin as the light diffusing element enables reduction of the amount of phosphor that is used through an effect of light scattering, whereas the combined use of this silicone resin with a hydrogenated styrene copolymer as the base material enables a surprising degree of stabilization of temporal variation in the chromaticity of output light.

<2> The wavelength conversion member according to the foregoing <1>, wherein
the hydrogenated styrene copolymer is a styrene-ethylene-butylene-styrene block copolymer elastomer.
<3> The wavelength conversion member according to the foregoing <1> or <2>, wherein
the light diffusing element is a silicone resin particle.
<4> The wavelength conversion member according to the foregoing <3>, wherein
the silicon resin particle has a particle diameter of 2 $\mu$m or more.
<5> The wavelength conversion member according to any one of the foregoing <1> to <4>, wherein
the phosphor is a sulfide phosphor.
<6> The wavelength conversion member according to the foregoing <5>, wherein
the sulfide phosphor includes either or both of a red sulfide phosphor and a green sulfide phosphor.
<7> The wavelength conversion member according to the foregoing <6>, wherein
the red sulfide phosphor is a calcium sulfide phosphor and the green sulfide phosphor is a thiogallate phosphor.
<8> The wavelength conversion member according to any one of the foregoing <1> to <7>, wherein
an absolute value of a difference between a refractive index of the hydrogenated styrene copolymer and a refractive index of the silicone resin is 0.04 or more.
<9> The wavelength conversion member according to any one of the foregoing <1> to <8>, wherein
the wavelength conversion member is sheet-shaped.
<10> A phosphor sheet comprising:

the wavelength conversion member according to the foregoing <9>; and
a substrate that sandwiches the wavelength conversion member.

<11> The phosphor sheet according to the foregoing <10>, wherein
the substrate is a water vapor barrier film.
<12> The phosphor sheet according to the foregoing <11>, wherein
the water vapor barrier film has a water vapor permeability of 0.05 g/m$^2$/day to 20 g/m$^2$/day.
<13> A white light source device comprising the wavelength conversion member according to any one of the foregoing <1> to <9>.
<14> A display device comprising the white light source device according to the foregoing <13>.

(Advantageous Effect)

According to this disclosure, it is possible to provide a wavelength conversion member and a phosphor sheet that can be produced at low cost and can suppress temporal variation in the chromaticity of light when used in a light source device. Moreover, according to this disclosure, it is possible to provide a white light source device and a display device that can be produced at low cost and in which temporal variation in the chromaticity of light is suppressed.

BRIEF DESCRIPTION OF THE DRAWINGS

In the accompanying drawings:

FIGS. 1A, 1B, and 1C conceptually illustrate the effect of a light diffusing element in a wavelength conversion member according to a disclosed embodiment;
FIG. 2 schematically illustrates a phosphor sheet according to a disclosed embodiment; and
FIG. 3 schematically illustrates configuration of a light source used in evaluation of examples.

DETAILED DESCRIPTION

(Wavelength conversion member)

The following describes a wavelength conversion member according to a disclosed embodiment.
The wavelength conversion member according to the disclosed embodiment (hereinafter, also referred to simply as the "presently disclosed wavelength conversion member") contains at least a phosphor, a light diffusing element, and a base material, and may contain a coloring material and other optional elements as necessary.

<Phosphor>

The phosphor contained in the presently disclosed wavelength conversion member has a property of performing wavelength conversion of at least a portion of incident light and releasing emitted light of a different wavelength to the incident light. The phosphor is held in the base material with the subsequently described light diffusing element.
The phosphor can be selected as appropriate depending on the objective, type, absorption band, light emission band, and so forth without any specific limitations other than having the property described above. For example, from a material viewpoint, sulfide phosphors, oxide phosphors, nitride phosphors, fluoride phosphors, other phosphors (YAG phosphors and SiAlON phosphors), and the like can be used, and from a color viewpoint, red phosphors, green phosphors, yellow phosphors, and the like can be used. One of these phosphors may be used individually, or two or more of these phosphors may be used in combination. Of these phosphors, sulfide phosphors are preferable in terms that color reproduction with a wide color gamut is possible as a result of having a sharp light emission spectrum. However, sulfide phosphors are generally susceptible to degradation due to water vapor in a high-temperature and high-humidity environment, which makes it difficult to adopt sulfide phosphors in white LEDs. Therefore, in a case in which a sulfide phosphor is used, it is preferable that a phosphor layer serving as the wavelength conversion member is formed in a sheet-shape and is covered with a substrate having low water vapor permeability.
Examples of sulfide phosphors that may be used in this disclosure include red sulfide phosphors and green sulfide phosphors. More specifically, the sulfide phosphor that may be used in this disclosure preferably includes either or both of a red sulfide phosphor and a green sulfide phosphor.
When a mixture of a red sulfide phosphor and a green sulfide phosphor is used as the sulfide phosphor, the resultant wavelength conversion member can suitably be used in a white light source device that includes a blue light-emitting diode.
The red sulfide phosphor may, for example, be a red sulfide phosphor that exhibits a red fluorescence peak at a wavelength of 620 nm to 670 nm upon irradiation with blue excitation light. Specific examples include CaS:Eu (calcium sulfide (CS) phosphor) and SrS:Eu. One of these red sulfide phosphors may be used individually, or two or more of these red sulfide phosphors may be used in combination.
The green sulfide phosphor may, for example, be a green sulfide phosphor that exhibits a green fluorescence peak at a wavelength of 530 nm to 550 nm upon irradiation with blue excitation light. Specific examples include thiogallate (SGS) phosphor $(Sr_xM_{1-x-y})Ga_2S_4:Eu_y$ (M is any of Ca, Mg, and Ba; $0 \leq x < 1$ and $0 < y < 0.2$ are satisfied).
In a case in which a mixture of a red sulfide phosphor and a green sulfide phosphor is used as the phosphor, the proportion constituted by the red sulfide phosphor among all phosphor is preferably 40 mass% to 60 mass%. This allows white light with a wide color gamut to be obtained in a white light source device that includes a blue light-emitting diode.
The amount of the phosphor per unit area in the wavelength conversion member can be selected as appropriate depending on the specifications of the phosphor, the chromaticity point of the light source, diffusing characteristics of a light diffusing element of a light source member, and so forth without any specific limitations. The amount of the phosphor per unit area in the wavelength conversion member is derived from factors of phosphor concentration in a phosphor layer and thickness of the phosphor layer, and due to the combined use of a silicone resin as the light diffusing element, in addition to the above-described constraints, may be 4 g/m$^2$ or less, for example.

<Light diffusing element>

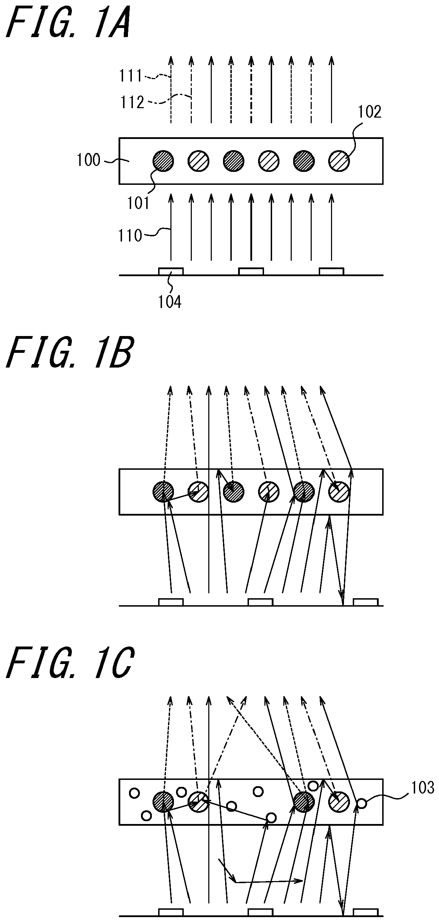

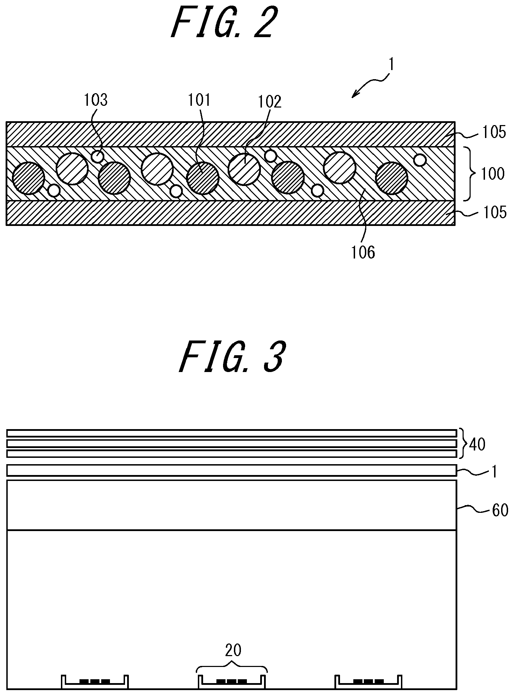

The light diffusing element contained in the presently disclosed wavelength conversion member has a property of diffusing light emitted from the phosphor in the wavelength conversion member and/or a light-emitting element such as a light-emitting diode. The following provides a conceptual explanation of the effect of the light diffusing element in the wavelength conversion member using, as an example, a case in which a red phosphor and a green phosphor are used as the phosphor and in which a blue light-emitting diode is used as a light source. A wavelength conversion member 100 illustrated in FIG. 1A includes 3 units of each of a red phosphor 101 and a green phosphor 102. In this example, 9 units of blue light (these units may be thought of as photons) are emitted from blue light-emitting diodes 104. Of this blue light, 6 units of blue light are converted to 3 units of red light 111 and 3 units of green light 112, and 3 units of blue light are output externally through scattering by reflection and the like. Through this process, blue light 110, converted red light 111, and converted green light 112 can be thought to be output externally while being scattered by reflection and the like as illustrated in FIG. 1B. In contrast, in a case in which a light diffusing element 103 is added to the wavelength conversion member 100, even if the number of units of the red phosphor 101 and the green phosphor 102 is reduced to 2 units each as illustrated in FIG. 1C, 3 units of red light 111, 3 units of green light 112, and 3 units of blue light 110 can be output and color conversion can be performed as desired. This is because the presence of the light diffusing element 103 increases scattering of blue light 110 in the wavelength conversion member 100 and thereby increases opportunities for absorption of the blue light 110 by the phosphors. Consequently, the amount of phosphor that is used can be reduced to 2/3 in the present example.

The light diffusing element used in this disclosure is required to be a silicone resin. When a silicone resin is used as the light diffusing element, combined use with a hydrogenated styrene copolymer as the base material enables a surprising degree of stabilization of temporal variation in the chromaticity of output light.

Note that the presently disclosed wavelength conversion member may further contain optional elements other than the silicone resin as the light diffusing element. However, it is preferable that the presently disclosed wavelength conversion member only contains the silicone resin as the light diffusing element from a viewpoint of obtaining the desired effects.

Although the form of the silicone resin can be selected as appropriate depending on the objective without any specific limitations, the silicone resin is preferably in particulate form. In other words, the light diffusing element contained in the presently disclosed wavelength conversion member is preferably one or more silicone resin particles. When the silicone resin used as the light diffusing element is in particulate form, light can be diffused more uniformly and the amount of phosphor that is used can be reduced without negatively affecting optical properties.

Although the particle diameter of the silicone resin particles can be selected as appropriate depending on the objective without any specific limitations, the particle diameter is preferably 2 μm or more, and is preferably 20 μm or less, and more preferably 5 μm or less from a viewpoint of light scattering. When the silicone resin particles have a particle diameter of 2 μm or more, aggregation of the silicone resin particles in a production process of the wavelength conversion member can be inhibited and quality of the wavelength conversion member can be more reliably maintained. Moreover, when the silicone resin particles have a particle diameter of 20 μm or less, quality of a phosphor layer (anticipated to normally be approximately 30 μm to 70 μm in thickness) used as the wavelength conversion member can be maintained in terms of coating surface quality, surface smoothness, and so forth.

In the present specification, "particle diameter" refers to the average particle diameter calculated based on a particle volume distribution.

Although the concentration of the light diffusing element in the wavelength conversion member can be selected as appropriate depending on the objective without any specific limitations, the light diffusing element concentration is preferably at least equal to the phosphor concentration and not more than 10 times the phosphor concentration. When the light diffusing element concentration is at least equal to the phosphor concentration, the amount of phosphor that is used can be reduced because effective light scattering occurs. Moreover, when the light diffusing element concentration is not more than 10 times the phosphor concentration, it is possible to inhibit deterioration of optical properties such as luminance, occurrence of unevenness during phosphor coating, reduction of adhesion strength to a substrate, and so forth.

<Base material>

The base material contained in the presently disclosed wavelength conversion member is a material for holding the light diffusing element. More specifically, the base material according to this disclosure may be formed from a resin composition and may have the light diffusing element dispersed therein.

The base material used in this disclosure is required to include a hydrogenated styrene copolymer. When a hydrogenated styrene copolymer is used as the base material, combined use with the silicone resin used as the light diffusing element enables a surprising degree of stabilization of temporal variation in the chromaticity of output light from the wavelength conversion member. It is thought that because double bonds have been removed from the hydrogenated styrene copolymer by hydrogenation, reactivity between the hydrogenated styrene copolymer and the phosphor is significantly lowered, and discoloration of the base material itself and discoloration of output light can be effectively inhibited.

Moreover, the hydrogenated styrene copolymer has properties of high water vapor barrier performance and low water absorbency. The hydrogenated styrene copolymer can, therefore, advantageously inhibit phosphor degradation, particularly in a case in which a sulfide phosphor that is vulnerable to water is used as the phosphor.

Furthermore, because the hydrogenated styrene copolymer is thermoplastic, the wavelength conversion member can be obtained using the hydrogenated styrene copolymer without performing a curing operation such as is necessary in a case in which an energy ray-curable silicone resin is used, for example. This enables low cost production of the wavelength conversion member.

The hydrogenated styrene copolymer can be selected as appropriate depending on the objective without any specific limitations and may, for example, be a styrene-ethylene-butylene-styrene block copolymer elastomer (SEBS), a styrene-ethylene-propylene block copolymer elastomer (SEP), a styrene-ethylene-propylene-styrene block copolymer elastomer (SEPS), or a styrene-ethylene-ethylene-propylene-styrene block copolymer elastomer (SEEPS). One of these hydrogenated styrene copolymers may be used individually, or two or more of these hydrogenated styrene copolymers may be used in combination. Of these hydrogenated styrene copolymers, a styrene-ethylene-butylene-styrene block copolymer elastomer is preferable in terms of enabling stabilization of temporal variation in the chromaticity of output light.

Although the proportion constituted by styrene units in the hydrogenated styrene copolymer can be selected as appropriate depending on the objective without any specific limitations, the proportion constituted by styrene units is preferably 20 mass% to 40 mass%. A styrene unit content of 20 mass% or more in the hydrogenated styrene copolymer enables improvement of mechanical strength of the base material, whereas a styrene unit content of 40 mass% or less in the hydrogenated styrene copolymer inhibits embrittlement of the base material.

With regards to refractive index, the absolute value of the difference between the refractive index of the hydrogenated styrene copolymer that is used and the refractive index of the silicone resin that is used as the light diffusing element is preferably 0.04 or more, and more preferably 0.08 or more. When this absolute value is 0.04 or more, sufficient light scattering occurs and an effect of reducing the amount of phosphor that is used can be sufficiently achieved. The absolute value is preferably 0.8 or less, but this is not a specific limitation.

Moreover, no specific limitations are placed on which out of the hydrogenated styrene copolymer and the silicone resin has a larger refractive index value.

The base material that is used in this disclosure may further include a resin other than the hydrogenated styrene copolymer. Examples of resins other than the hydrogenated styrene copolymer that can be used include known thermoplastic resins and photocurable resins.

However, the proportion constituted by the hydrogenated styrene copolymer among resin included in the base material is preferably 60 mass% or more, and more preferably 70 mass% or more from a viewpoint of more effectively stabilizing temporal variation in the chromaticity of output light.

<Coloring material>

The presently disclosed wavelength conversion member may contain a coloring material so long as the objectives of this disclosure are not impeded. The coloring material is a substance that absorbs light of a desired wavelength region. The coloring material may be an organic compound or an inorganic compound, and may be a pigment or a dye. However, a dye that is an organic compound is preferable in terms of homogeneous dispersion and dissolution in resin.

The coloring material may be dispersed in the base material in any concentration without any specific limitations.

<Shape>

The shape of the presently disclosed wavelength conversion member can be selected as appropriate depending on the objective without any specific limitations. For example, the presently disclosed wavelength conversion member may be sheet-shaped, dome-shaped, or tube-shaped. In a planar light source device that uses a light-emitting diode, the presently disclosed wavelength conversion member may, among these shapes, suitably be sheet-shaped since this enables use of the wavelength conversion member as a phosphor layer included in a phosphor sheet.

In a case in which the presently disclosed wavelength conversion member is sheet-shaped, the thickness of the wavelength conversion member can be selected as appropriate depending on the objective without any specific limitations, but is preferably 20 μm to 200 μm, and more preferably 40 μm to 100 μm. It is difficult to form a sheet-shaped wavelength conversion member uniformly if the thickness of the sheet-shaped wavelength conversion member is too thin or too thick.

<Production method of wavelength conversion member>

In the case of a sheet-shaped wavelength conversion member, the wavelength conversion member may be formed on any substrate. When used in a phosphor sheet of a light source device including the sheet-shaped wavelength conversion member and a light-emitting diode, the sheet-shaped wavelength conversion member may be formed directly on a substrate of the phosphor sheet. The following describes a production method of the phosphor sheet in such a situation.

(Phosphor sheet)

A presently disclosed phosphor sheet includes a sheet-shaped wavelength conversion member and a pair of substrates, and may further include other members that are appropriately selected as necessary. The substrates are normally transparent and plate-shaped, and adopt a configuration in which the presently disclosed wavelength conversion member set forth above is sandwiched thereby.
As a result of including the presently disclosed wavelength conversion member set forth above, the presently disclosed phosphor sheet can be produced at low cost and can suppress temporal variation in the chromaticity of light when used in a light source device.
FIG. 2 schematically illustrates a phosphor sheet according to a disclosed embodiment. A phosphor sheet 1 illustrated in FIG. 2 includes a phosphor layer 100 as a wavelength conversion member and a pair of substrates 105 that sandwich the phosphor layer 100. The phosphor layer 100 contains a red phosphor 101 and a green phosphor 102 as phosphors, a light diffusing element 103, and a base material 106. Specifically, the base material 106 holds the light diffusing element 103, and also holds the red phosphor 101 and the green phosphor 102.
It should be noted that the presently disclosed phosphor sheet is not limited to the embodiment set forth above and is also inclusive of, for example, a phosphor sheet obtained by laminating any other member (for example, a layer containing a coloring material) on one surface or both surfaces of a phosphor layer and then sandwiching the resultant laminate between a pair of substrates, and a phosphor sheet obtained by laminating any other member (for example, a layer containing a coloring material) on the surface of either or both of a pair of substrates that sandwich a phosphor layer. Moreover, the presently disclosed phosphor sheet may be a sealed product obtained by heating the edges of a pair of substrates that sandwich a phosphor layer such as to weld the substrates to one another.

<Substrates>

The substrates can be selected as appropriate depending on the objective without any specific limitations and may, for example, be thermoplastic resin films, thermosetting resin films, or photocurable resin films (JP 2011-13567 A, JP 2013-32515 A, and JP 2015-967 A).
The substrate material can be selected as appropriate depending on the objective without any specific limitations and may, for example, be polyester film such as polyethylene terephthalate (PET) film or polyethylene naphthalate (PEN) film; polyamide film; polyimide film; polysulfone film; triacetyl cellulose film; polyolefin film; polycarbonate (PC) film; polystyrene (PS) film; polyethersulfone (PES) film; cyclic amorphous polyolefin film; polyfunctional acrylate film; polyfunctional polyolefin film; unsaturated polyester film; epoxy resin film; or fluororesin film such as PVDF, FEP, or PFA film. One of these substrate materials may be used individually, or two or more of these substrate materials may be used in combination.
Of these substrate materials, polyethylene terephthalate (PET) film and polyethylene naphthalate (PEN) film are particularly preferable.
The surface of these films may be subjected to corona discharge treatment, silane coupling agent treatment, or the like as necessary to enhance adhesiveness to a layer in contact therewith.
The thickness of the substrates can be selected as appropriate depending on the objective without any specific limitations, but is preferably 10 μm to 100 μm.
The substrates are preferably water vapor barrier films in order to further reduce degradation caused by phosphor hydrolysis (particularly of a sulfide phosphor) or the like. The water vapor barrier films may be gas barrier films obtained by forming a metal oxide thin film of aluminum oxide, magnesium oxide, silicon oxide, or the like on the surface of a plastic base plate or film made from PET or the like, and may, for example, have a multi-layer structure such as a PET/SiOx/PET structure.
Although the water vapor permeability of the water vapor barrier films can be selected as appropriate depending on the objective without any specific limitations, the water vapor permeability is preferably 0.05 g/m$^2$/day to 20 g/m$^2$/day,

and more preferably 0.05 g/m$^2$/day to 5 g/m$^2$/day (for example, comparatively low barrier performance of approximately 0.1 g/m$^2$/day). When the water vapor permeability is within any of the ranges set forth above, this inhibits entry of water vapor and protects the phosphor layer from water vapor.

The water vapor permeability may, for example, be a value measured under conditions of a temperature of 40°C and a humidity of 90%.

<Other members>

The presently disclosed phosphor sheet may include a cover member or the like at the edge thereof without any specific limitations. Moreover, the cover member may include a reflecting layer of aluminum foil or the like.

Although the water vapor permeability of the cover member can be selected as appropriate depending on the objective without any specific limitations, the water vapor permeability is preferably 1 g/m$^2$/day or less.

(Production of phosphor sheet)

The following describes one example of a method for producing the presently disclosed phosphor sheet.

The method includes at least a stirring step (A) and a lamination step (B), and may further include a punching step (C) and a sealing step (D) as necessary.

-Stirring step (A)-

The stirring step (A) may involve, for example, dissolving a resin including a hydrogenated styrene copolymer in a solvent to produce a binder and subsequently mixing a phosphor and a light diffusing element in a predetermined compounding ratio to obtain a paste mixture. Note that in a case in which the phosphor sheet serving as the wavelength conversion member is to contain a coloring material, the coloring material may be mixed together with the phosphor and the light diffusing element in a predetermined compounding ratio. The solvent can be selected as appropriate depending on the objective without any specific limitations other than being a solvent in which the resin including the hydrogenated styrene copolymer dissolves and may, for example, be toluene, methyl ethyl ketone, or a mixture thereof.

The proportion constituted by the resin in the paste mixture is preferably 10 mass% to 40 mass%, and more preferably 20 mass% to 30 mass% because adhesiveness is inadequate if this proportion is too small and the resin does not dissolve in the solvent if this proportion is too large.

-Lamination step (B)-

The lamination step (B) may involve, for example, applying the paste mixture onto a first substrate and then using a bar coater to equalize the coating thickness. Next, the paste mixture that has been applied is dried in an oven to remove the solvent and form a phosphor layer as a wavelength conversion member. A device such as a thermal laminator may then be used to laminate a second substrate onto the phosphor layer and thereby obtain a phosphor sheet (web) in which the phosphor layer is sandwiched between the first substrate and the second substrate.

The method by which the paste mixture is applied onto the substrate is not specifically limited and may be a known method.

-Punching step (C)-

The punching step may involve, for example, punching the phosphor sheet web obtained through the lamination step (B) in a pressing machine to obtain a phosphor sheet of a specific size having the phosphor layer exposed at the side surface thereof.

-Sealing step (D)-

The sealing step (D) may involve, for example, using aluminum foil tape as a cover member to seal the phosphor layer exposed between the first substrate and the second substrate in the phosphor sheet obtained through the punching step (C).

(White light source device)

A presently disclosed white light source device includes at least the presently disclosed wavelength conversion member. More specifically, the presently disclosed white light source device includes the presently disclosed phosphor sheet and may include other members such as a light-emitting diode and a mounting substrate as necessary. As a result of including the presently disclosed wavelength conversion member set forth above, the presently disclosed white light source device can be produced at low cost and temporal variation in the chromaticity of light is suppressed therein. Examples of the presently disclosed white light source device include lighting devices and the like for various applications such as backlights of liquid-crystal displays.

The white light source device may include a blue light-emitting diode (LED) and the presently disclosed phosphor sheet. In such a case, the presently disclosed phosphor sheet preferably contains either or both of a red sulfide phosphor and a green sulfide phosphor.

(Display device)

A presently disclosed display device includes at least the presently disclosed white light source device, and may further include an optical film for light ray control, a liquid-crystal panel, and other members as necessary.

As a result of including a white light source device that includes the presently disclosed wavelength conversion member set forth above, the presently disclosed display device can be produced at low cost and temporal variation in the chromaticity of light is suppressed therein. The presently disclosed display device may, for example, be a liquid-crystal display.

EXAMPLES

The following provides a more specific description of this disclosure through a reference example, examples, and comparative examples. However, this disclosure is not limited by the following examples.

<Production of green sulfide phosphor>

$Eu_2O_3$ (produced by Kojundo Chemical Laboratory Co., Ltd.; purity: 3N) was added to nitric acid aqueous solution (produced by Kanto Chemical Co., Inc.; concentration: 20%) and was stirred at 80°C to dissolve the $Eu_2O_3$ in the nitric acid aqueous solution. Thereafter, solvent was evaporated to obtain $Eu(NO_3)_3$. Next, the resultant $Eu(NO_3)_3$ and $Sr(NO_3)_2$ (produced by Kojundo Chemical Laboratory Co., Ltd.; purity: 3N) were added to 500 mL of pure water and were stirred to obtain a solution. Powdered $Ga_2O_3$ (produced by Kojundo Chemical Laboratory Co., Ltd.; purity: 7N) was added to this solution in a specific proportion, and ammonium sulfite monohydrate (produced by Kanto Chemical Co., Inc.) was dripped into the solution under stirring to obtain a precipitate that was a mixture of europium strontium sulfite and gallium oxide. Note that the dripped amount of ammonium sulfite monohydrate was a number of moles equivalent to 1.5 times the total number of moles of Sr and Eu in the solution. The resultant precipitate was washed with pure water and filtered until a conductivity of 0.1 mS/cm or less was reached, and was then dried for 6 hours at 120°C to obtain a powder (mixture of europium strontium sulfite powder and gallium oxide powder). Note that this method is referred to as a "wet method" (i.e., a method in which a starting material is produced in a liquid phase).

A pot having a capacity of 500 mL was charged with 20 g of the resultant powder, 200 g of zirconia balls, and 200 mL of ethanol, and was rotated at a rotation speed of 90 rpm for 30 minutes to perform mixing. Thereafter, the contents of the pot were filtered and were dried for 6 hours at 120°C. Next, the dried product was passed through a mesh having a nominal opening size of 100 $\mu$m to obtain a powder mixture. The powder mixture was baked in an electric furnace under conditions of heating to 925°C over 1.5 hours, holding at 925°C for 1.5 hours, and then cooling to room temperature over 2 hours. During the baking, hydrogen sulfide was caused to flow in the electric furnace in a proportion of 0.5 L/minute. The post-baking powder mixture was passed through a mesh having a nominal opening size of 25 $\mu$m to obtain a green sulfide phosphor ($Sr_{1-x}Ga_2S_4:Eu_x$; x is approximately 0.1).

Note that the value of x in $Sr_{1-x}Ga_2S_4:Eu_x$ can be adjusted by appropriately altering the added amounts of $Eu(NO_3)_3$ and $Sr(NO_3)_2$. This enables adjustment of the concentration of Eu, which acts as a luminescent center.

<Preparation of red sulfide phosphor>

A red sulfide phosphor produced by Mitsui Mining & Smelting Co., Ltd. (R660N; CaS:Eu) was prepared.

(Reference Example 1)

<Production of phosphor sheet>

First, two water vapor barrier films (water vapor permeability under conditions of a temperature of 40°C and a humidity of 90%: approximately 0.2 $g/m^2/day$) each having a three-layer PET/vapor deposited SiOx/PET structure and a thickness of 38 $\mu$m were prepared as substrates.

A binder was separately produced by dissolving a styrene-ethylene-butylene-styrene block copolymer elastomer (SEBS) (SEPTON V9827 produced by Kuraray Co., Ltd.; styrene unit content: 30 mass%) in toluene as a solvent. The concentration of SEBS in the binder was 32 mass%. The green sulfide phosphor and the red sulfide phosphor described above were added to and mixed with the binder to obtain a paste mixture. The proportion constituted by the green sulfide phosphor among the total amount of phosphor was 57.0 mass%. Moreover, the phosphor (green sulfide phosphor + red sulfide phosphor) concentration in a finally obtained phosphor layer was 8.81 mass%.

Next, the paste mixture was applied onto the surface of a water vapor barrier film such as described above using a roll coater, and was dried to volatilize solvent and form a phosphor layer. A water vapor barrier film of the same type was thermally laminated on the phosphor layer. In this manner, a phosphor sheet was produced that included the phosphor layer as a wavelength conversion member and the water vapor barrier films as substrates sandwiching the phosphor layer. The thickness of the phosphor layer was 63 $\mu$m.

<Light source for phosphor sheet evaluation>

FIG. 3 illustrates the configuration of a light source that was used for evaluation.

The light source had a size of 300 mm in length by 200 mm in width by 30 mm in height, and included blue LEDs in a square array at a pitch of 30 mm. The blue LEDs had a peak wavelength of approximately 449 nm during light emission. The blue LEDs were supplied with 5.5 W of electrical power.

A spectral radiance meter (SR-3 produced by Topcon Technohouse Corporation) was used to measure the light emission spectrum of a sample with respect to the light source including the produced phosphor sheet.

<Evaluation of phosphor sheet>

This light source was used to determine (x,y) chromaticity for the obtained phosphor sheet based on the CIE 1931 color system using the spectral radiance meter. The results were an x value of 0.277 and a y value of 0.238. Moreover, the luminance determined with respect to the obtained phosphor sheet using the spectral radiance meter was 3,518 cd/m$^2$.

The obtained phosphor sheet was then exposed to an environment having a temperature of 60°C and a relative humidity of 85% for 5,000 hours. The chromaticity of the phosphor sheet after exposure was measured using the light source. The chromaticity difference $\Delta$u'v' before and after exposure was determined to be 0.0074. In calculation of the chromaticity difference, (x,y) chromaticity was converted to (u',v') chromaticity based on the CIE 1976 color system. The chromaticity difference $\Delta$u'v' is defined as follows.

($u_0'$,$v_0'$): Initial chromaticity
(u',v'): Chromaticity after 5,000 hours
Chromaticity difference

$$\text{Chromaticity difference } \Delta u'v' = ((u' - u_0')^2 + (v' - v_0')^2)^{0.5}$$

$$u' = 4x/(-2x + 12y + 3)$$

$$v' = 9y/(-2x + 12y + 3)$$

Note that the reason that the chromaticity difference was expressed using the CIE 1976 color system is that (u',v') chromaticity in the CIE 1976 color system has higher linearity with the chromaticity difference perceived by a person than (x,y) chromaticity in the CIE 1931 color system.

(Example 1-1)

<Production of phosphor sheet>

First, two water vapor barrier films (water vapor permeability under conditions of a temperature of 40°C and a humidity of 90%: approximately 0.2 g/m$^2$/day) each having a three-layer PET/vapor deposited SiOx/PET structure and a thickness of 38 $\mu$m were prepared as substrates.

A binder was separately produced by dissolving a styrene-ethylene-butylene-styrene block copolymer elastomer (SEBS) (SEPTON V9827 produced by Kuraray Co., Ltd.) as a base material in toluene as a solvent. The concentration of SEBS in the binder was 32 mass%. The green sulfide phosphor and the red sulfide phosphor described above were added to and mixed with the binder, and then silicone resin powder (KMP-590 produced by Shin-Etsu Chemical Co., Ltd.) was further added as a light diffusing element to obtain a paste mixture. The light diffusing element concentration was 0.67 times the phosphor concentration. Moreover, the phosphor (green sulfide phosphor + red sulfide phosphor) concentration in a finally obtained phosphor layer was 8.47 mass%.

Next, the paste mixture was applied onto the surface of a water vapor barrier film such as described above using a roll coater, and was dried to volatilize solvent and form a phosphor layer. A water vapor barrier film of the same type was thermally laminated on the phosphor layer. In this manner, a phosphor sheet was produced that included the phosphor layer as a wavelength conversion member and the water vapor barrier films as substrates sandwiching the phosphor layer.

Note that the proportion constituted by the green sulfide phosphor among the total amount of phosphor and the thickness of the phosphor layer were appropriately adjusted such that the (x,y) chromaticity of the phosphor sheet was roughly the same as in Reference Example 1.

The (x,y) chromaticity, luminance, and chromaticity difference Δu'v' before and after exposure were determined with respect to the obtained phosphor sheet in the same way as in Reference Example 1.

(Example 1-2)

A phosphor sheet was produced in the same way as in Example 1-1 with the exception that the phosphor (green sulfide phosphor + red sulfide phosphor) concentration in the finally obtained phosphor layer was set as 8.01 mass% and the light diffusing element concentration was set as 1.67 times the phosphor concentration.

Note that the proportion constituted by the green sulfide phosphor among the total amount of phosphor and the thickness of the phosphor layer were appropriately adjusted such that the (x,y) chromaticity of the phosphor sheet was roughly the same as in Reference Example 1.

The (x,y) chromaticity, luminance, and chromaticity difference Δu'v' before and after exposure were determined with respect to the obtained phosphor sheet in the same way as in Reference Example 1.

(Example 1-3)

A phosphor sheet was produced in the same way as in Example 1-1 with the exception that the phosphor (green sulfide phosphor + red sulfide phosphor) concentration in the finally obtained phosphor layer was set as 7.60 mass% and the light diffusing element concentration was set as 2.67 times the phosphor concentration.

Note that the proportion constituted by the green sulfide phosphor among the total amount of phosphor and the thickness of the phosphor layer were appropriately adjusted such that the (x,y) chromaticity of the phosphor sheet was roughly the same as in Reference Example 1.

The (x,y) chromaticity, luminance, and chromaticity difference Δu'v' before and after exposure were determined with respect to the obtained phosphor sheet in the same way as in Reference Example 1.

The ratio of the amount of phosphor used in each of Examples 1-1 to 1-3 relative to the amount of phosphor used in Reference Example 1 (i.e., the relative amount of phosphor used in each of Examples 1-1 to 1-3) was calculated by taking into account the weight ratio and specific gravity of used materials (phosphor, resin, and light diffusing element). Moreover, the luminance in each of Examples 1-1 to 1-3 relative to the luminance in Reference Example 1 (i.e., the relative luminance in each of Examples 1-1 to 1-3) was calculated.

Next, a graph was prepared by plotting the measurement results for Reference Example 1 and Examples 1-1 to 1-3 with the light diffusing element concentration on the horizontal axis (x-axis) and the amount of phosphor on the vertical axis (y-axis). A regression value for the relative amount of phosphor when the light diffusing element concentration is 2 times the phosphor concentration was determined as Example 1. Moreover, a regression value for the relative luminance when the light diffusing element concentration is 2 times the phosphor concentration was determined as Example 1 by the same method.

These regression values were more specifically determined from the aforementioned graph by regression as a quadratic function $y = ax^2 + bx + c$, determining the coefficients a, b, and c, and then determining y through substitution of x = 2.

(Comparative Example 1-1)

A phosphor sheet was produced in the same way as in Example 1-1 with the exception that a melamine resin (silica composite) A (OPTBEADS 2000M produced by Nissan Chemical Industries, Ltd.) was used as the light diffusing element instead of silicone resin powder.

Note that the proportion constituted by the green sulfide phosphor among the total amount of phosphor and the thickness of the phosphor layer were appropriately adjusted such that the (x,y) chromaticity of the phosphor sheet was roughly the same as in Reference Example 1.

The (x,y) chromaticity, luminance, and chromaticity difference Δu'v' before and after exposure were determined with respect to the obtained phosphor sheet in the same way as in Reference Example 1.

(Comparative Example 1-2)

A phosphor sheet was produced in the same way as in Comparative Example 1-1 with the exception that the phosphor (green sulfide phosphor + red sulfide phosphor) concentration in the finally obtained phosphor layer was set as 8.01 mass% and the light diffusing element concentration was set as 1.67 times the phosphor concentration.

Note that the proportion constituted by the green sulfide phosphor among the total amount of phosphor and the thickness of the phosphor layer were appropriately adjusted such that the (x,y) chromaticity of the phosphor sheet was roughly the same as in Reference Example 1.

The (x,y) chromaticity, luminance, and chromaticity difference Δu'v' before and after exposure were determined with respect to the obtained phosphor sheet in the same way as in Reference Example 1.

The results of Comparative Examples 1-1 and 1-2 were used to determine a regression value for the relative amount of phosphor when the light diffusing element concentration is 2 times the phosphor concentration as Comparative Example 1 by the same method as for Examples 1-1 to 1-3. Moreover, a regression value for the relative luminance when the light diffusing element concentration is 2 times the phosphor concentration was determined as Comparative Example 1 by the same method.

(Comparative Example 2-1)

A phosphor sheet was produced in the same way as in Comparative Example 1-1 with the exception that a melamine resin (silica composite) B (OPTBEADS 3500M produced by Nissan Chemical Industries, Ltd.) was used as the light diffusing element instead of the melamine resin (silica composite) A.

Note that the proportion constituted by the green sulfide phosphor among the total amount of phosphor and the thickness of the phosphor layer were appropriately adjusted such that the (x,y) chromaticity of the phosphor sheet was roughly the same as in Reference Example 1.

The (x,y) chromaticity and luminance were determined with respect to the obtained phosphor sheet in the same way as in Reference Example 1.

(Comparative Example 2-2)

A phosphor sheet was produced in the same way as in Comparative Example 2-1 with the exception that the phosphor (green sulfide phosphor + red sulfide phosphor) concentration in the finally obtained phosphor layer was set as 8.31 mass% and the light diffusing element concentration was set as 1.00 times the phosphor concentration.

Note that the proportion constituted by the green sulfide phosphor among the total amount of phosphor and the thickness of the phosphor layer were appropriately adjusted such that the (x,y) chromaticity of the phosphor sheet was roughly the same as in Reference Example 1.

The (x,y) chromaticity and luminance were determined with respect to the obtained phosphor sheet in the same way as in Reference Example 1.

(Comparative Example 2-3)

A phosphor sheet was produced in the same way as in Comparative Example 2-1 with the exception that the phosphor (green sulfide phosphor + red sulfide phosphor) concentration in the finally obtained phosphor layer was set as 8.01 mass% and the light diffusing element concentration was set as 1.67 times the phosphor concentration.

Note that the proportion constituted by the green sulfide phosphor among the total amount of phosphor and the thickness of the phosphor layer were appropriately adjusted such that the (x,y) chromaticity of the phosphor sheet was roughly the same as in Reference Example 1.

The (x,y) chromaticity and luminance were determined with respect to the obtained phosphor sheet in the same way as in Reference Example 1.

The results of Comparative Examples 2-1 to 2-3 were used to determine a regression value for the relative amount of phosphor when the light diffusing element concentration is 2 times the phosphor concentration as Comparative Example 2 by the same method as for Examples 1-1 to 1-3. Moreover, a regression value for the relative luminance when the light diffusing element concentration is 2 times the phosphor concentration was determined as Comparative Example 2 by the same method.

(Comparative Example 3-1)

A phosphor sheet was produced in the same way as in Comparative Example 1-1 with the exception that an acrylic copolymer elastomer (KURARITY LA2140e produced by Kuraray Co., Ltd.) was used as the base material instead of SEBS.

Note that the proportion constituted by the green sulfide phosphor among the total amount of phosphor and the thickness of the phosphor layer were appropriately adjusted such that the (x,y) chromaticity of the phosphor sheet was roughly the same as in Reference Example 1.

The (x,y) chromaticity, luminance, and chromaticity difference $\Delta u'v'$ before and after exposure were determined with respect to the obtained phosphor sheet in the same way as in Reference Example 1.

(Comparative Example 3-2)

A phosphor sheet was produced in the same way as in Comparative Example 3-1 with the exception that the phosphor (green sulfide phosphor + red sulfide phosphor) concentration in the finally obtained phosphor layer was set as 8.01 mass% and the light diffusing element concentration was set as 1.67 times the phosphor concentration.

Note that the proportion constituted by the green sulfide phosphor among the total amount of phosphor and the thickness of the phosphor layer were appropriately adjusted such that the (x,y) chromaticity of the phosphor sheet was roughly the same as in Reference Example 1.

The (x,y) chromaticity, luminance, and chromaticity difference $\Delta u'v'$ before and after exposure were determined with respect to the obtained phosphor sheet in the same way as in Reference Example 1.

(Comparative Example 3-3)

A phosphor sheet was produced in the same way as in Comparative Example 3-1 with the exception that the phosphor (green sulfide phosphor + red sulfide phosphor) concentration in the paste mixture was set as 8.81 mass% and the light diffusing element concentration was set as 2.67 times the phosphor concentration.

Note that the proportion constituted by the green sulfide phosphor among the total amount of phosphor and the thickness of the phosphor layer were appropriately adjusted such that the (x,y) chromaticity of the phosphor sheet was roughly the same as in Reference Example 1.

The (x,y) chromaticity, luminance, and chromaticity difference $\Delta u'v'$ before and after exposure were determined with respect to the obtained phosphor sheet in the same way as in Reference Example 1.

The results of Comparative Examples 3-1 to 3-3 were used to determine a regression value for the relative amount of phosphor when the light diffusing element concentration is 2 times the phosphor concentration as Comparative Example 3 by the same method as for Examples 1-1 to 1-3. Moreover, a regression value for the relative luminance when the light diffusing element concentration is 2 times the phosphor concentration was determined as Comparative Example 3 by the same method.

(Evaluation of relative amount of phosphor)

The relative amount of phosphor in each example was evaluated based on the following standard using the regression value for the relative amount of phosphor when the light diffusing element concentration is 2 times the phosphor concentration.

Excellent: Less than 0.7
Good: At least 0.7 and less than 0.8
Poor: 0.8 or more

(Evaluation of relative luminance)

The relative luminance in each example was evaluated based on the following standard using the regression value for the relative luminance when the light diffusing element concentration is 2 times the phosphor concentration.

Excellent: 0.98 or more
Good: At least 0.90 and less than 0.98

Poor: Less than 0.90

(Evaluation of chromaticity difference Δu'v' before and after exposure)

An evaluation of good was given for each example in which the measured chromaticity difference Δu'v' before and after exposure was less than 0.01 and an evaluation of poor was given for each example in which the measured chromaticity difference Δu'v' before and after exposure was 0.01 or more.
The results are shown in Table 1.

Table 1

| | | Base material | | Light diffusing element | | | Absolute value of refractive index difference of base material and light diffusing element | Phosphor concentration in phosphor layer (mass%) | Light diffusing element concentration in phosphor layer (times) (relative to phosphor) | Proportion of green sulfide phosphor among total amount of phosphor (mass%) | Phosphor layer thickness (μm) | Chromaticity x value | Chromaticity y value | Luminance (cd/m²) | Relative amount of phosphor | Relative luminance | Chromaticity difference Δu'v' before and after exposure |
|---|---|---|---|---|---|---|---|---|---|---|---|---|---|---|---|---|---|
| | | Type | Refractive index | Type | Average particle diameter (μm) | Refractive index | | | | | | | | | | | |
| Reference Example 1 | | Hydrogenated styrene copolymer | 1.513 | None | - | 1.43 | 0.083 | 8.81 | 0 | 57.0 | 63 | 0.277 | 0.238 | 3518 | 1.00 | 1.00 | 0.0074 |
| Example 1 | Example 1-1 | Hydrogenated styrene copolymer | 1.513 | Silicone resin (KMP-590) | 2.0 | 1.43 | 0.083 | 8.47 | 0.67 | 54.6 | 56 | 0.277 | 0.238 | 3498 | 0.87 | 0.99 | 0.0046 |
| | Example 1-2 | | | | | | | 8.01 | 1.67 | 51.9 | 51 | 0.277 | 0.238 | 3489 | 0.75 | 0.99 | 0.0052 |
| | Example 1-3 | | | | | | | 7.60 | 2.67 | 50.9 | 49 | 0.277 | 0.238 | 3471 | 0.70 | 0.99 | 0.0043 |
| | Regression value | | | | | | | - | 2 | - | - | 0.277 | 0.238 | - | 0.74 (regression value) | 0.99 (regression value) | - |
| | | | | | | | | | | | | Evaluation: | | | Good | Excellent | Good |
| Comparative Example 1 | Comparative Example 1-1 | Hydrogenated styrene copolymer | 1.513 | Melamine resin (silica composite) A (OPTBEADS 2000M) | 1.8 | 1.65 | 0.137 | 8.47 | 0.67 | 52.1 | 50 | 0.277 | 0.238 | 3479 | 0.77 | 0.99 | 0.0106 |
| | Comparative Example 1-2 | | | | | | | 8.01 | 1.67 | 49.0 | 43 | 0.277 | 0.238 | 3433 | 0.65 | 0.98 | 0.0133 |
| | Regression value | | | | | | | - | 2 | - | - | 0.277 | 0.238 | - | 0.63 (regression value) | 0.97 (regression value) | - |
| | | | | | | | | | | | | Evaluation: | | | Excellent | Good | Poor |
| Comparative Example 2 | Comparative Example 2-1 | Hydrogenated styrene copolymer | 1.513 | Melamine resin (silica composite) B (OPTBEADS 3500M) | 3.5 | 1.65 | 0.137 | 8.47 | 0.67 | 52.9 | 56 | 0.277 | 0.238 | 3520 | 0.89 | 0.98 | Not measured |
| | Comparative Example 2-2 | | | | | | | 8.31 | 1.00 | 51.3 | 54 | 0.277 | 0.238 | 3502 | 0.86 | 0.97 | Not measured |
| | Comparative Example 2-3 | | | | | | | 8.01 | 1.67 | 49.3 | 51 | 0.277 | 0.238 | 3471 | 0.79 | 0.97 | Not measured |
| | Regression value | | | | | | | - | 2 | - | - | 0.277 | 0.238 | - | 0.77 (regression value) | 0.96 (regression value) | - |
| | | | | | | | | | | | | Evaluation: | | | Good | Good | Poor (predicted to be similar to Comparative Example 1) |
| Comparative Example 3 | Comparative Example 3-1 | Acrylic copolymer elastomer | 1.47 | Melamine resin (silica composite) A (OPTBEADS 2000M) | 1.8 | 1.65 | 0.180 | 8.47 | 0.67 | 50.1 | 52 | 0.277 | 0.238 | 3384 | 0.77 | 0.97 | 0.0107 |
| | Comparative Example 3-2 | | | | | | | 8.01 | 1.67 | 48.1 | 44 | 0.277 | 0.238 | 3357 | 0.64 | 0.96 | 0.0108 |
| | Comparative Example 3-3 | | | | | | | 8.81 | 2.67 | 47.4 | 45 | 0.277 | 0.238 | 3301 | 0.63 | 0.64 | 0.0184 |
| | Regression value | | | | | | | - | 2 | - | - | 0.277 | 0.238 | - | 0.63 (regression value) | 0.95 (regression value) | - |
| | | | | | | | | | | | | Evaluation: | | | Excellent | Good | Poor |

The results in Table 1 demonstrate that by using a material including a hydrogenated styrene copolymer as a base material and by also using a silicone resin as a light diffusing element, it is possible to obtain a wavelength conversion member in which the amount of phosphor, which is generally expensive, can be reduced while also sufficiently suppressing variation in chromaticity even after 5,000 hours of use, for example.

INDUSTRIAL APPLICABILITY

According to this disclosure, it is possible to provide a wavelength conversion member and a phosphor sheet that can be produced at low cost and can suppress temporal variation in the chromaticity of light when used in a light source device. Moreover, according to this disclosure, it is possible to provide a white light source device and a display device that can be produced at low cost and in which temporal variation in the chromaticity of light is suppressed.

REFERENCE SIGNS LIST

1      phosphor sheet
20     blue LED package
40     optical films
60     diffusing plate
100    wavelength conversion member (phosphor layer)
101    red phosphor
102    green phosphor
103    light diffusing element

| 104 | blue light-emitting diode |
| 105 | substrate |
| 106 | base material |
| 110 | blue light |
| 111 | red light |
| 112 | green light |

**Claims**

1. A wavelength conversion member comprising:

   a phosphor that performs wavelength conversion of at least a portion of incident light and releases emitted light of a different wavelength to the incident light;
   a light diffusing element that diffuses either or both of the incident light and the emitted light; and
   a base material that holds the light diffusing element, wherein
   the light diffusing element is a silicone resin, and
   the base material includes a hydrogenated styrene copolymer.

2. The wavelength conversion member according to claim 1, wherein
   the hydrogenated styrene copolymer is a styrene-ethylene-butylene-styrene block copolymer elastomer.

3. The wavelength conversion member according to claim 1 or 2, wherein
   the light diffusing element is a silicone resin particle.

4. The wavelength conversion member according to claim 3, wherein
   the silicon resin particle has a particle diameter of 2 $\mu$m or more.

5. The wavelength conversion member according to claim 1 or 2, wherein
   the phosphor is a sulfide phosphor.

6. The wavelength conversion member according to claim 5, wherein
   the sulfide phosphor includes either or both of a red sulfide phosphor and a green sulfide phosphor.

7. The wavelength conversion member according to claim 6, wherein
   the red sulfide phosphor is a calcium sulfide phosphor and the green sulfide phosphor is a thiogallate phosphor.

8. The wavelength conversion member according to claim 1 or 2, wherein
   an absolute value of a difference between a refractive index of the hydrogenated styrene copolymer and a refractive index of the silicone resin is 0.04 or more.

9. The wavelength conversion member according to claim 1 or 2, wherein
   the wavelength conversion member is sheet-shaped.

10. A phosphor sheet comprising:

    the wavelength conversion member according to claim 9; and
    a substrate that sandwiches the wavelength conversion member.

11. The phosphor sheet according to claim 10, wherein
    the substrate is a water vapor barrier film.

12. The phosphor sheet according to claim 11, wherein
    the water vapor barrier film has a water vapor permeability of 0.05 g/m$^2$/day to 20 g/m$^2$/day.

13. A white light source device comprising the wavelength conversion member according to claim 1 or 2.

14. A display device comprising the white light source device according to claim 13.

## FIG. 1A

## FIG. 1B

## FIG. 1C

## FIG. 2

1

103  101  102

105

100

105

106

## FIG. 3

40

1

60

20

## INTERNATIONAL SEARCH REPORT

| | International application No. |
|---|---|
| | PCT/JP2016/003676 |

A.  CLASSIFICATION OF SUBJECT MATTER
*H01L33/50*(2010.01)i, *C09K11/02*(2006.01)i, *C09K11/56*(2006.01)i, *C09K11/62* (2006.01)i, *H01L33/58*(2010.01)i

According to International Patent Classification (IPC) or to both national classification and IPC

B.  FIELDS SEARCHED

Minimum documentation searched (classification system followed by classification symbols)
H01L33/00-33/64

Documentation searched other than minimum documentation to the extent that such documents are included in the fields searched
  Jitsuyo Shinan Koho          1922–1996   Jitsuyo Shinan Toroku Koho    1996–2016
  Kokai Jitsuyo Shinan Koho    1971–2016   Toroku Jitsuyo Shinan Koho    1994–2016

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
|---|---|---|
| Y | JP 2013-32515 A   (Dexerials Corp.), 14 February 2013 (14.02.2013), paragraphs [0049], [0050]; fig. 1 & US 2014/0097461 A1 paragraphs [0055], [0056]; fig. 1 & WO 2013/005791 A1    & EP 2730616 A1 & TW 201309783 A       & CN 103649215 A & KR 10-2014-0035979 A | 1-14 |
| Y | JP 2013-32516 A   (Dexerials Corp.), 14 February 2013 (14.02.2013), paragraphs [0045], [0046]; fig. 1 & US 2014/0124813 A1 paragraphs [0050], [0051]; fig. 1 & WO 2013/005793 A1    & EP 2730610 A1 & TW 201307464 A       & CN 103635524 A & KR 10-2014-0035978 A | 1-14 |

☒  Further documents are listed in the continuation of Box C.          ☐  See patent family annex.

| | |
|---|---|
| *     Special categories of cited documents:<br>"A"   document defining the general state of the art which is not considered    to be of particular relevance<br>"E"   earlier application or patent but published on or after the international filing date<br>"L"   document which may throw doubts on priority claim(s) or which is cited to establish the publication date of another citation or other special reason (as specified)<br>"O"   document referring to an oral disclosure, use, exhibition or other means<br>"P"   document published prior to the international filing date but later than the priority date claimed | "T"   later document published after the international filing date or priority date and not in conflict with the application but cited to understand the principle or theory underlying the invention<br>"X"   document of particular relevance; the claimed invention cannot be considered novel or cannot be considered to involve an inventive step when the document is taken alone<br>"Y"   document of particular relevance; the claimed invention cannot be considered to involve an inventive step when the document is combined with one or more other such documents, such combination being obvious to a person skilled in the art<br>"&"   document member of the same patent family |

| Date of the actual completion of the international search | Date of mailing of the international search report |
|---|---|
|     09 September 2016 (09.09.16) |     20 September 2016 (20.09.16) |

| Name and mailing address of the ISA/<br>    Japan Patent Office<br>    3-4-3,Kasumigaseki,Chiyoda-ku,<br>    Tokyo 100-8915,Japan | Authorized officer<br><br><br>Telephone No. |
|---|---|

Form PCT/ISA/210 (second sheet) (January 2015)

**INTERNATIONAL SEARCH REPORT**

| International application No. |
| --- |
| PCT/JP2016/003676 |

C (Continuation). DOCUMENTS CONSIDERED TO BE RELEVANT

| Category* | Citation of document, with indication, where appropriate, of the relevant passages | Relevant to claim No. |
| --- | --- | --- |
| Y | WO 2014/017501 A1 (Mitsubishi Chemical Corp.), 30 January 2014 (30.01.2014), paragraphs [0058], [0062] & JP 2015-181140 A & JP 2014-78691 A & TW 201414019 A | 1-14 |
| Y | JP 2015-59202 A (Dexerials Corp.), 30 March 2015 (30.03.2015), paragraph [0042]; fig. 1 & WO 2015/040855 A1 & EP 3048157 A paragraph [0045]; fig. 1 & TW 201514277 A & CN 105555914 A | 11-12 |
| A | JP 2014-78691 A (Mitsubishi Chemical Corp.), 01 May 2014 (01.05.2014), entire text; all drawings & JP 2015-181140 A & WO 2014/017501 A1 & TW 201414019 A | 1-14 |

Form PCT/ISA/210 (continuation of second sheet) (January 2015)

REFERENCES CITED IN THE DESCRIPTION

**Patent documents cited in the description**

- JP 2015166111 A
- JP 2014078691 A
- JP 2011013567 A
- JP 2013032515 A
- JP 2015000967 A